# EUROPÄISCHE PATENTANMELDUNG

(11) **EP 1 304 400 A1**
(43) Veröffentlichungstag der Anmeldung: **23.04.2003**
(21) Anmeldenummer: 01124734.3
(22) Anmeldetag: 17.10.2001
(51) Int. Cl.: C30B 15/36, C30B 29/06, C30B 29/08

(54) **Verfahren zur Herstellung von Kristallviellingen mit exakt symmetrischen monokristallinen Bereichen aus Schmelzen von Silizium, Germanium und deren Legierungen zur Verwendung als Halbleiter-, Optik- und Photovoltaiksubstrate**

(71) Anmelder: Siepe, Volker, Dr., 97078 Würzburg (DE)
(72) Erfinder: Siepe, Volker, Dr., 97078 Würzburg (DE)

(57) **Zusammenfassung**

Verfahren zur Herstellung von Kristallviellingen mit exakt symmetrischen monokristallinen Bereichen aus Schmelzen von Silizium, Germanium und deren Legierungen zur Verwendung als Halbleiter-, Optik- und Photovoltaiksubstrate mit folgenden Schritten:
(1) Herstellen eines Saatkristalles aus einem in einer Kristallachse-orientierten Silizium, Germanium und deren Legierungen bestehenden Monokristall dergestalt, daß man durch zentrisches Bohren und/oder Sägen und/oder Fräsen einen einer Zahnwurzel gleichenden Kristall herstellt, dessen zylinder-, kegel-, pyramiden- oder kreissektorförmige Spitzen zur Züchtung von Viellingskristallen in simultaner Kristallisation verwendet werden können. Die gezüchteten Kristalle können ihrerseits als Saatkristalle eingesetzt werden oder kommerziell genutzt werden.
(2) Herstellen eines Saatkristallviellings durch Anbringen von klassischen Saatkristallen an eine tellerartige Vorrichtung mit Möglichkeit zur Justierung der einzelen Saatkristalle um deren Längachse dergestalt, daß nach deren Orientierung die Anordnung zur Züchtung von Kristallviellingen eingesetzt werden kann.
(3) Herstellen eines Saatkristallviellings durch Fixierung von Monokristallen, in diesem Falle klassiche Saatkristalle, durch Zusammenbinden entsprechend den gewünschten Kristallachsen mit z.B. einem Platindraht, Wolframdraht, oder durch einen Siliziumring mit Siliziumschrauben so zu verspannen und dieses Bündel, flächig, gespitzt oder kegelförmig verjüngt für die Züchtung des Viellings zu verwenden.
(4) Anordnung der Spiegelflächen der Kristallsektoren dergestalt, daß die Fehlstellendiffusion zur Peripherie des Gesamtkristalls gerichtet wird
(5) Anordnung und Formgebung der zylinder-, kegel-, pyramidenförmigen Spitzen bzw. der Kreissektorflächen hinsichtlich der Höhe der Spitzen und deren Lage auf der Kreisfläche des Saatkristalles dergestalt, daß während der im folgenden durchgeführten Kristallzüchtung eine optimale Kristallstruktur der Viellinge erzeugt wird.
(6) Benutzung der in (1) bis (5) beschriebenen Anordnungen um in einer Czochralski-Züchtungsanlage Kristallviellinge aus einer Silizium, Germanium und deren Legierungen bestehenden Schmelze zu ziehen, deren monokristalline Bereiche den kristallographischen Regeln folgen und diese für die Züchtung weiterer Kristallviellinge einzusetzen oder wie in (7) kommerziell zu nutzen.
(7) Benutzung der erhaltenen Kristallviellingsstäbe um daraus durch Sägen, Bohren, Schleifen, Fräsen Halbleiterscheiben oder optische Komopnenten herzustellen.

## Beschreibung

In der Photovoltaik werden Halbleiterscheiben aus Silizium oder Germanium benötigt, deren optimale Dicke auf Grund der Absorption der Photonen bei ca. 100 µm liegt (DE 43 43 296 C 2 u.a.). G. Martinelli hat in Solid State Phenomena Bd. 32-33 (1993) S. 21 - 25 die Herstellung eines Trikristalls beschrieben, dessen monokristalline Bereiche aus drei gegeneinander verkippten <111>-Kristallen erzeugt wurden. Die Hauptwachstumsrichtung dieses Trikristalls ist die <110>-Richtung der Einzelkristalle; es ist aber seit lamgem bekannt, daß in dieser Richtung sich die Fehlstellen anhäufen (vgl. Handbook of Semiconductor Silicon Technology (1990) S. 128 ff.). Die Sektoren der monokristallinen Bereiche dieses Trikristalls sind nicht exakt rotationssymmetrisch 120° sondern ca. 109, ca. 125° und 125°; dadurch werden beim Wachstum zwischen den <111>-Bereichen Lamellen (=Übergangskristalle) erzeugt, die höheren Indizes der Spiegelebenen entsprechen, so. z.B. <221> und <552> (vgl. Finnisches Patent 106729 v. 20.03.01). Diese Lamellen (=Zwischenkristalle) sind aber die Ursache von Versetzungen (=Störstellen) im Kristall, die letztendlich dazu führen, daß am Ende des Ziehens von längeren Trikristallen die Zahl der Fehlstellen zunimmt bis ein ungeordneter Kristall entsteht, also das Material multikristallin kristallisiert und der Ziehvorgang abgebrochen werden muß. Zusätzlich muß ein solcher Trikristall immer geprüft werden wie weit die Fehlstellen am Ende des Ziehvorgangs in den Kristall zurückdiffundiert sind; das Material mit multikristallinen Bereichen muß abgeschnitten werden und ist für Solarzellen nicht einsetzbar. Dies bedeutet zusätzlichen Prüfaufwand, Materialverlust und Zusatzarbeit. Schließlich ist zu erwähnen, daß die fehlende exakte Rotationssymmetrie beim Einsatz der Solarzellen in Solarpanels vom Auge als störend empfunden wird.

In der Optik können die nach dem Patent DE 43 43 296 C 2 erzeugten Kristalle nicht eingesetzt werden, weil die Spiegelfläche zwischen den monokristallinen Bereichen nicht scharf ist (s.o. Finnisches Patent), sodaß die Ausnutzung des Glanzwinkels der Fläche für halbdurchlässige Spiegel oder andere Anwendungen, bei denen eine innere Berührungsfläche von monokristallinen Bereichen mit definierten Änderungen der Kristalleigenschaften benötigt wird, auscheidet.

Aufgabe der vorliegenden Erfindung ist es, ein Verfahren zur Herstellung von Kristallviellingen aus Silizium, Germanium und deren Legierungen anzugeben, mit dem diese unter Vermeidung der oben angeführten Nachteile - insbesondere der Vermeidung von Übergangskristallamellen - mit nahezu idealen Kristallparametern hergestellt werden können.

Diese Aufgabe wird erfindungsgemäß gelöst mit einem Verfahren nach Anspruch 1 bis 4. Weitere Ausgestaltungen der Erfindung sowie bevorzugte Verwendungen sind den weiteren Ansprüchen zu entnehmen.

Das Produkt des Verfahrens sind kristallographisch ideal ausgebildete Kristallviellinge, die neben den auf der Kristallsymmetrie beruhenden mechanischen Eigenschaften entsprechende optische Eigenschaften zeigen, die den Einsatz als Strahlteiler, innerer Spiegel, Biprisma etc. im Infrarot Licht erlauben.

Der Vorteil der erzeugten Kristallviellinge ist deren perfekte Kristallstruktur, die nach den gewünschten Kristallparametern zweckorientiert entworfen werden kann: so kann z.B. aus einem in <111>-Richtung gezüchteten Monokristall, oder dem 'Top' eines solchen Kristalls, nach der im folgenden beschriebenen Formgebung zum dreizähligen dendritischen Saatkristall, ein Trikristall gezogen werden. Dabei erzielt man eine höhere Wachtumsrate in der <111>-Richtung als beim einzelnen Monokristall, weil alle 3 Kristallisationszentren gleichzeitig in dieser Richtung wachsen und diese außerhalb der Rotationsachse auf einer kreisförmigen 'Bahn' in der kälteren Zone des Tiegels sitzen (vgl. Handbook of Semiconductor Silicon Technology (1990) S. 99 ff.); zusätzlich liegen die <110>-Flächen der zum Trikristall zusammengewachsenen Einzelkristalle auf der äußeren Peripherie des Gesamtkristalls, sodaß die möglichen Fehlstellen in der kalten Zone liegen und eine Rückdiffusion nur senkrecht zur Hauptwachstumsrichtung - also zur Peripherie des Drillings - erfolgen kann. Außerdem erhält man eine gute mechanische Stabilität einer quadratisch geschnittenen Scheibe, weil keine Kristallachse quer durch die ganze Scheibe verläuft. Somit ist der Züchtungsvorgang ökonomischer und führt zu reproduzierbaren versetzungsfreien Produkten im Gegensatz zum reinen Monokristall und den erwähnten Patenten.

Für den Einsatz in der Infrarotoptik erhält man aus solchen Trikristallen nach dem Schneiden senkrecht zur gemeinsamen <111>-Achse und Runden um diese Achse z.B. einen rotationssymmetrischen IR-Spiegel an den 120° versetzten gemeinsamen Kristallsektorflächen.

Herstellung eines zahnwurzelartigen Saatkristalls zur Züchtung von Trikristallen(Drillingen) mit Hauptwachstumsrichtung <111>

Ein herkömmlich in Richtung der <111> gezogener Einzelkristall (=Mutterkristall) oder ein sog. Top aus Silizium, Germanium oder deren Legierung wird an seinem oberen Ende im Durchmesser auf ein Maß verjüngt, daß er exakt in die Halterung eines Kristallzüchtungsofens paßt.

An seinem unteren Ende wird zunächst eine konzentrische Bohrung oder Einfräsung in <111>-Richtung eingebracht; der Durchmesser des 'Loches' richtet sich nach dem Durchmesser des zu züchtenden Trikristalls und zwar dergestalt, daß die nach unten zur Schmelze zeigenden wurzelartigen Saatspitzen mit ihrer Hauptwachstumsrichtung <111> auf einem Kreis liegen, dessen Radius etwa bei der Hälfte des Durchmessers des gewünschten Trikristalls liegt. Dadurch wird erreicht, daß das Wachstum nach Außen und zur Mitte etwa gleich groß wird. Anschließend wird die Form der Wurzeln im einfachsten Fall durch radiale Einschnitte exakt an den <110>- oder <211>-Spiegelflächen des 'Mutterkristalls' in Kreissektorform festgelegt. Bei dem als Beispiel angeführten Trikristall wird bei Ausrichtung der Einschnitte in <211>-Richtung der Einzelkristalle außerdem die Diffusion der Fehlstellen in Richtung der Außenfläche des Gesamtkristalls d.h. in <110>-Richtung erreicht.

Als weitere Alternative unter Umgehung der Benutzung von EINEM Mutterkristall kann man eine tellerartige Vorrichtung zur Halterung (Lochplatte) von z.B. 3 bis n klassischen Saatkristallen benutzen unter der Vorausetzung, daß die Orientierung der Saatkristalle zueinander so exakt wie möglich denen eines Monokristalls nahe kommt; dies erreicht man z.B. durch Fixierung der Kristalle mit Tellerfedern o.ä. auf der Lochplatte, sodaß durch Drehen deren Orientierung zueinander beliebig, entsprechend den gewünschten kristallographischen Achsen, justiert werden kann. Als Werkstoff für diese Halterung kommen temperaturbeständige Stähle oder zur Vermeidung der Verunreinigung auch hochreines Silizium in Frage.

Schließlich kann man auch klassische Saatkristalle, nachdem man deren Orientierung mit einem Goniometer festgestellt hat und z.B. die <110>-Ebene durch Abschleifen freigelegt hat, also Kreissektoren mit einen Winkel von 120 Grad erzeugt hat, mit einem Platin- oder Wolframdraht umwickeln bzw. mit einem Siliziumring verspannen und dann dieses Bündel flächig-, gespitzt-, oder kegelförmig verjüngt für die Züchtung des Viellings verwenden.

### ZÜCHTUNG DER KRISTALLVIELLINGE

Der zahnwurzelartige Monokristall, die auf der tellerartigen Vorrichtung fixierten und zueinander justierten Saatkristalle oder das beschriebene Kristallbündel werden in einer Czochralski-Züchtungsanlage zur Züchtung von Kristallviellingen verwendet.
Dazu wird wie bei der Monokristallzüchtung zunächst in einem 'Dip'-Vorgang ein Teil der im Beispiel genannten 'Wurzeln' abgeschmolzen, um Fehlstellen und Verunreinigungen zu beseitigen. Anschließend werden durch Unterkühlung und einen relativ schnellen Ziehvorgang auf allen Wurzelstümpfen Zonen geordneten Kristallwachstums aufgebracht, die dann durch langsameres Ziehen im sog. 'Neck'-Vorgang zusammenwachsen. Es kann nötig sein nach dem Zusammenwachsen nochmals einen weiteren Dip- und Neck-Vorgang durchzuführen, um eine stabile Kristallstruktur zu erhalten. Der so erhaltene schmale Kristall kann dann bis auf Nennaußenmaß gezüchtet werden. Wichtig ist nach dem Züchtungsvorgang die ausreichende Temperung des Kristalls, um die mechanischen Spannungen zu minimieren.

## Patentansprüche

1. Verfahren zur Herstellung von Kristallviellingen mit exakt symmetrischen monokristallinen Bereichen aus Silizium, Germanium und deren Legierungen zur Verwendung als Halbleiter-, Optik- und Photovoltaiksubstrate mit folgenden Schritten:
- Herstellen eines Saatkristalles aus einem in einer Kristallachse-orientierten Silizium, Germanium und deren Legierungen bestehenden Monokristall dergestalt, daß man durch zentrisches Bohren und/oder Sägen und/oder Fräsen einen einer Zahnwurzel gleichenden Kristall herstellt, dessen zylinder-, kegel-, pyramiden- oder kreissektorförmige Spitzen zur Züchtung von Viellingskristallen in simultaner Kristallisation aus einer Schmelze von Silizium, Geramnium oder deren Legierung verwendet werden kann.
- Herstellen eines Saatkristallviellings durch Anbringen von klassischen Saatkristallen aus Silizium, Germanium und deren Legierungen an eine tellerartige Vorrichtung mit Möglichkeit zur Justierung der einzelen Saatkristalle um deren Längachse dergestalt, daß nach deren Orientierung die Anordnung zur Züchtung von Kristallviellingen eingesetzt werden kann.
- Herstellen eines Saatkristallviellings durch Fixierung von Monokristallen, in diesem Falle klassiche Saatkristalle aus Silizium, Germanium und deren Legierungen, durch Zusammenzubinden entsprechend den gewünschten Kristallachsen mit z.B. einem Platindraht, Wolframdraht, oder mit einen Siliziumring und Siliziumschrauben so zu verspannen und dieses Bündel, flächig, gespitzt oder kegelförmig verjüngt für die Züchtung des Viellings zu verwenden.

2. Verfahren nach Anspruch 1 **gekennzeichnet dadurch, daß** die beschriebenen Anordnungen der Saatkristalle in Richtung der Schmelze Zylinder-, Pyramiden-, Kegel-, oder Kreissektorform besitzen

3. Verfahren nach Anspruch 1 und/oder 2 bei dem die beschriebenen Anordnungen in einer Czochralski-Züchtungsanlage zur Herstellung von Kristallviellingen aus einer Silizium, Germanium und deren Legierungen bestehenden Schmelze eingesetzt werden.

4. Verfahren nach Anspruch 1 bis 3 bei dem die Anordnung der der Spiegelflächen der Kristallsektoren derartig gewählt wird, daß die Fehlstellendiffusion zur Peripherie des Gesamtkristalls gerichtet wird.

5. Verfahren nach einem der Ansprüche 1 bis 4, bei dem die erhaltenen Kristallviellinge als neue Saatkristalle oder direkt zur kommerziellen Nutzung eingesetzt werden.

6. Verfahren nach einem der Ansprüche 1 bis 5, bei dem aus den erhaltenen Kristallviellingsstäben durch Sägen, Bohren, Schleifen, Fräsen Scheiben oder andere geometrische Formen hergestellt werden.

7. Verfahren nach einem der Ansprüche 1 bis 6, bei dem die Scheiben für die Herstellung von Halbleitern und Solarzellen eingesetzt werden.

8. Verfahren nach einem der Ansprüche 1 bis 7, bei dem die durch Sägen, Bohren, Schleifen, Fräsen hergestellten geometrischen Formen zur Herstellung von optischen Komponenten eingesetzt werden
